# FASCICULE DE BREVET EUROPEEN

(11) **EP 2 157 613 B1**
(45) Date de publication et mention de la délivrance du brevet: **09.10.2019**
(21) Numéro de dépôt: 08290791.6
(22) Date de dépôt: 20.08.2008
(51) Int. Cl.: H01L 29/88, H01L 29/778, H01L 27/06, H01L 29/205, H01L 29/08, H01L 29/20, H01L 21/20, H01L 21/02

(54) **Procédé d'intégration monolithique de RITD pseudomorphique et de transistor à base de matériaux III-V**
Monolithisches Integrationsverfahren von pseudomorphen resonanten Tunneldioden (RITD) und Transistor auf der Basis von III-V-Materialien
Method for monolithic integration of a pseudomorphic Resonant Interband Tuneling Diode (RITD) and a transistor made from III-V materials

(43) Date de publication de la demande: 24.02.2010
(73) Titulaire: OMMIC, 94453 Limeil-Brévannes (FR)
(72) Inventeur: Maher, Hassan, 91300 Massy (FR)
(74) Mandataire: Fédit-Loriot

(56) Documents cités:
- EP-A- 0 272 885
- WO-A-97/17723
- WO-A-2008/073469
- LEWIS J H ET AL: "Metamorphic In0.53Ga0.47As/In0.52Al0.48As tunnel diodes grown on GaAs" COMPOUND SEMICONDUCTORS, 2000 IEEE INTERNATIONAL SYMPOSIUM ON 2-5 OCT. 2000, PISCATAWAY, NJ, USA,IEEE, 2 octobre 2000 (2000-10-02), pages 143-148, XP010555549 ISBN: 978-0-7803-6258-1
- AUER U ET AL: "A novel 3-D integrated RTD-HFET frequency multiplier" 1997 INT. CONFERENCE ON INDIUM PHOSPHIDE AND RELATED MATERIALS. HYANNIS, CAPE COD, MAY 11 - 15, 1997; [INDIUM PHOSPHIDE AND RELATED MATERIALS], NEW YORK, NY : IEEE, US, 11 mai 1997 (1997-05-11), pages 373-375, XP010231996 ISBN: 978-0-7803-3898-2
- GEOK ING NG ET AL: "Are We There Yet ? --- A Metamorphic HEMT and HBT Perspective" EUROPEAN GALLIUM ARSENIDE AND OTHER SEMICONDUCTOR APPLICATION SYMPOSIU M, GAAS 2005 OCT. 3, 2005, PISCATAWAY, NJ, USA,IEEE, 3 octobre 2005 (2005-10-03), pages 13-20, XP010918847 ISBN: 978-88-902012-0-2

## Description

La présente invention concerne une structure semi-conductrice permettant de réaliser de manière monolithique une diode à effet tunnel basée sur une hétérojonction de matériaux semi-conducteurs III-V tels que InAs/GaAsSb, sur un substrat InP.

Dans le domaine des diodes il est connu de réaliser une diode à partir d'une jonction comprenant deux couches l'une dopée N et l'autre dopée P.

Une diode classique est réalisée à partir d'une homojonction. Les deux couches sont alors composées de matériaux semi-conducteurs identiques, une première couche étant dopée P et la seconde étant dopée N.

Une diode Esaki ou diode à effet tunnel présente en plus une caractéristique courant-tension I = f (V) comportant une partie à pente négative et se comporte alors dans cette partie comme une résistance négative. Cette propriété est avantageusement mise à profit pour réaliser une détection directe de décalage de zéro ou pour mélanger la faible puissance d'un oscillateur local.

Une telle diode est réalisée soit en dopant fortement respectivement N et P, les deux couches d'une homojonction, soit en réalisant une hétérojonction composée de deux couches de matériaux semi-conducteurs différents, et tels que, sur un diagramme énergétique ou diagramme de bande, le minimum de la bande de conduction de la couche dopée N soit situé en dessous du maximum de la bande de valence de la couche dopée P. Ceci est encore équivalent à dire que l'on est en présence d'une jonction de type II. Ce second mode de réalisation permet avantageusement de réaliser une diode à effet tunnel en ne dopant que faiblement les deux couches de la jonction. Ceci est avantageux en ce qu'un dopage faible des couches permet d'obtenir une bonne stabilité en température.

Afin de pouvoir empiler des couches de matériaux semi-conducteurs pour réaliser une structure semi-conductrice, plusieurs conditions doivent être remplies. Chaque couche est constituée d'un matériau semi-conducteur cristallin composé d'au moins deux atomes. Tous les atomes sont classés dans le tableau périodique des éléments en fonction de leur valence de I à VIII. Pour qu'une composition cristalline soit stable, il convient que la somme des valences soit égale à huit. Il apparaît ainsi des familles de matériaux semi-conducteurs cristallins I-VII, II-VI, III-V, IV-IV. Ainsi SiC est un cristal stable de la famille IV-IV, Si et C ayant tout deux une valence IV. In et Ga ont une valence III. P, As et Sb ont une valence V. Ainsi InAs, InP, GaAsSb, InGaAs sont des cristaux stables de la famille III-V.

Les couches de matériaux semi-conducteurs sont obtenues de manière connue par croissance épitaxiale. Il n'est possible d'empiler de manière construite et donc durable deux couches que si elles présentent des cristaux de même caractéristiques. Il est ainsi nécessaire que le paramètre de maille qui détermine la dimension d'un cristal semi-conducteur soit identique de part et d'autre au niveau d'une interface entre deux couches. On dit encore que les deux cristaux semi-conducteurs sont en accord de maille.

Il est connu de réaliser des composants électroniques, tels que transistor à très haute mobilité électronique ou HEMT (de l'anglais High Electronic Mobility Transistor), transistor bipolaire à hétérojonction ou HBT (de l'anglais Heterojunction Bipolar Transistor), transistor à effet de champ à hétérostructure ou HFET (de l'anglais Heterostructure Field Effect Transistor) ou encore des DHBT ou autres, à partir d'un ensemble comportant plusieurs couches de matériaux semi-conducteurs, sur la base d'un substrat en matériau semi-conducteur InP ou GaAs métamorphique. Ces composants HEMT sont par exemple utilisés pour réaliser des circuits à hautes vitesses. La suite de la description détaille avec un composant HEMT. Cependant, l'enseignement de l'invention est transposable de manière directe aux autres composants (HBT, HFET, DHBT,...).

Il est encore connu de réaliser des diodes à effet tunnel à résonance inter bande ou RITD (de l'anglais Resonant Interband Tunnel Diode) sur la base d'une hétéro jonction InAs N / GaSb P. Ces RITD de la famille III-V sont particulièrement utilisées dans des applications de circuits logiques à basse puissance capable de fonctionner à des fréquences supérieures à 100 GHz.

Les matériaux semi-conducteurs InAs et InP présentent des paramètres de mailles différents, interdisant de déposer de manière durable une couche épaisse de InAs sur une couche de InP.

Actuellement pour intégrer un circuit comportant au moins un transistor HEMT et au moins une diode RITD basée sur une hétérojonction InAs/GaSb il est connu une première méthode dite hybride. Cette méthode comporte la réalisation de ladite diode sur une céramique qui est ensuite interfacée avec le circuit comportant lesdits transistors HEMT sur une couche support, tel un substrat InP ou GaAs métamorphique. Une telle interface conduit, du fait de l'intégration macroscopique de la céramique, à une utilisation peu efficace de l'espace d'insertion des composants. De plus l'interface avec la céramique introduit des parasites aux fréquences envisagées.

Une seconde méthode consiste à intercaler une couche métamorphique intermédiaire entre la couche support et la couche InAs qui réalise une interface en absorbant les contraintes dimensionnelles des réseaux cristallins en présence. Outre une épaisseur importante, cette couche métamorphique s'avère très complexe à mettre en oeuvre. De plus elle nécessite des cycles thermiques lors de sa réalisation qui, nécessairement appliqués aux couches sous jacentes InP et HEMT, leur sont préjudiciables.

Les documents "Metamorphic In0,53Ga0,47/In0,52 Al0,48As Tunnel diodes grown on GaAs" J.H. Lewis et al dans COMPOUND SEMICONDUCTORS, IEEE INTERNATIONAL SYMPOSIUM ON 2-5 OCT. 2000, WO-2008/073469 et WO-97/17723 peuvent aider à comprendre l'invention.

La présente invention remédie en tout ou partie à ces différents inconvénients en permettant de réaliser le dépôt d'une hétéro jonction de la famille InAs/GaAsSb sur un support InP ou équivalent en terme de paramètre de maille.

L'invention a pour objet une structure semi-conductrice en couches superposées pour réalisation de circuit intégré selon la revendication 1.

Selon une autre caractéristique de l'invention la couche support (3) est un substrat composé de matériau semi-conducteur InP ou GaAs métamorphique.

Selon une autre caractéristique de l'invention la couche support (3) est une couche composée de matériau semi-conducteur In_{0,53}Ga_{0,47}As.

Selon une autre caractéristique de l'invention la structure comprend encore dans l'ordre d'empilage :
- un substrat en matériau semi-conducteur InP (1) ou GaAs métamorphique,
- un ensemble HEMT (2) composé de plusieurs couches de matériaux semi-conducteurs, apte à la réalisation de transistors à haute mobilité électronique, HEMT, comportant une couche supérieure (3) composée de matériau semi-conducteur In_{0,53}Ga_{0,47}As.

Selon une autre caractéristique de l'invention le matériau semi-conducteur In_{0.53}Ga_{0.47}As est fortement dopé N, n++.

Selon une autre caractéristique de l'invention la couche dopée N (5) est une couche composée de matériau semi-conducteur InAs, faiblement dopé.

Selon l'invention la couche dopée P (6) est une couche composée de matériau semi-conducteur GaAsₓSb₁₋ₓ, faiblement dopé, avec x compris entre 0,35 et 0,65.

Selon une caractéristique avantageuse de l'invention x est sensiblement égal à 0,51.

Selon une autre caractéristique de l'invention la couche graduelle (4) est une couche composée de matériau semi-conducteur In_{y}Ga_{1-y}As, avec y variant graduellement en fonction de l'épaisseur de ladite couche graduelle, entre une valeur y sensiblement égale à 0,53 au contact de la couche support (3) et une valeur y sensiblement égale à 1 au contact de la couche dopée N (5).

Selon une autre caractéristique de l'invention la variation de y suit une loi continue.

Un avantage du dispositif selon l'invention est de permettre la réalisation d'une structure semi-conductrice intégrant de manière monolithique des diodes RITD pseudo morphiques et des transistors HEMT.

Un autre avantage de l'invention est de permettre de réaliser une diode RITD sur la base d'une jonction InAs/GaAsSb, alors qu'une telle jonction InAs/GaAsSb seule ne permet pas la réalisation d'une diode tunnel à cause de la présence de puits quantiques qui éliminent la conduction tunnel. La présence de la couche graduelle selon l'invention, supprime lesdits puits quantiques.

Ceci doit permettre la réalisation de circuits intégrés capables de grandes vitesses en augmentant les niveaux de courant de pilotage de sortie, les possibilités de pilotage multiple, ainsi que l'isolation entre les sorties. Un exemple d'application est par exemple la réalisation de récepteurs haute fréquence pour imagerie micro-onde.

D'autres caractéristiques, détails et avantages de l'invention ressortiront plus clairement de la description détaillée donnée ci-après à titre indicatif en relation avec des dessins sur lesquels :
- la figure 1 représente une vue en coupe d'une structure semi-conductrice illustrant le principe de l'invention,
- la figure 2 représente une vue en coupe d'une structure semi-conductrice selon l'invention selon un premier mode de réalisation,
- la figure 3 représente une vue en coupe d'une structure semi-conductrice selon l'invention selon un deuxième mode de réalisation,
- la figure 4 représente une vue en coupe d'une structure semi-conductrice selon l'invention selon un troisième mode de réalisation,
- la figure 5 représente un diagramme de bande de la structure selon l'invention,
- la figure 6 représente un exemple d'utilisation de la structure avec une intégration monolithique d'un HEMT et d'une RITD.

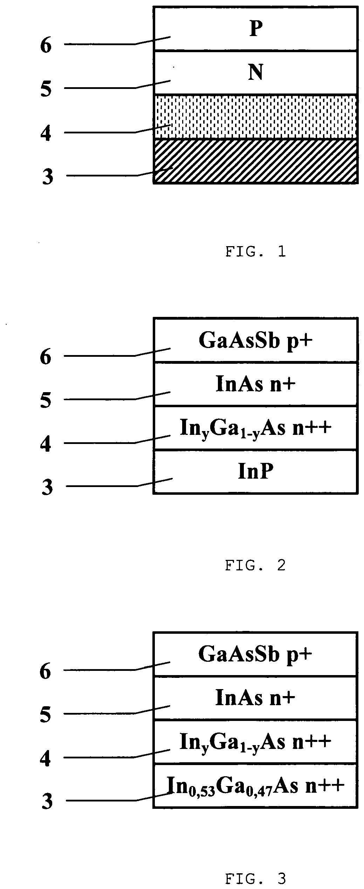

Sur la figure 1, la structure selon l'invention est représentée en vue coupée afin de faire apparaître les différentes couches superposées de matériaux semi-conducteurs la constituant. Par convention on considère dans la suite que les couches sont empilées de bas en haut. Dans cet ordre on trouve une première couche support 3. Cette couche support 3 est composée d'un matériau semi-conducteur III-V. Une caractéristique de cette couche est le paramètre de maille du réseau cristallin, ce premier paramètre de maille dépend du matériau constitutif de la couche. Au dessus de cette couche support 3 est disposée une couche dopée N, 5 composée d'un matériau semi-conducteur III-V. Ce matériau, de même famille III-V que celui de la couche support 3 présente un réseau de même nature cristalline et est compatible de la couche support 3. Une couche dopée P 6 est encore disposée au dessus de la couche dopée N 5. Cette couche dopée P 6 est composée d'un matériau semi-conducteur III-V. Ces deux couches sont telles que la couche dopée N 5 et la couche dopée P 6 forment ensemble une hétérojonction de type II apte à la réalisation d'une diode à effet tunnel à résonance inter bande, RITD.

Cependant, la couche dopée N 5 est caractérisée par un deuxième paramètre de maille différent du premier paramètre de maille de la couche support 3. Le premier paramètre de maille et le second paramètre de maille diffèrent au point que les réseaux cristallins de la couche support 3 et de la couche dopée N 5, ne pourraient pas directement être en accord de maille.

Le désaccord de maille entre les matériaux utilisés pour les couches 5, 6 des RITDs et les matériaux des couches support 3 est, dans le cas considéré, très important et présente un problème aujourd'hui critique.

Afin de réaliser par épitaxie des couches successives, superposées, solidaires entre elles, il est avantageux que tous les cristaux constituants soient en accord de maille. Si un désaccord de maille est dans certains cas acceptable, un tel désaccord produit des contraintes intra cristallines préjudiciables en ce qu'elles conduisent à des limitations de l'épaisseur de la structure semi-conductrice.

Aussi selon l'invention, la structure semi-conductrice comprend encore, entre la couche support 3 et la couche dopée N 5, une couche graduelle 4 composée d'un matériau cristallin III-V dont la composition stoechiométrique varie graduellement en fonction de l'épaisseur de ladite couche graduelle 4 afin de présenter un paramètre de maille graduellement variable, sensiblement égal au premier paramètre de maille au niveau de la surface de contact de la couche graduelle 4 avec la couche support 3 et sensiblement égal au deuxième paramètre de maille au niveau de la surface de contact de la couche graduelle 4 avec la couche dopée N 5. Il est à noter que pour que cette variation de composition soit possible, il faut que le matériau semi-conducteur constitutif de cette couche graduelle 4 comprenne au moins trois atomes. Autrement dit, le matériau constitutif doit être au moins ternaire.

Selon un premier mode de réalisation, illustré à la figure 2, la couche support 3 est un substrat composé de matériau semi-conducteur InP ou GaAs métamorphique.

Selon un second mode de réalisation, illustré à la figure 3, la couche support 3 sur laquelle est disposée la couche graduelle 4 comprend une couche composée de matériau semi-conducteur In_{0,53}Ga_{0,47}As.

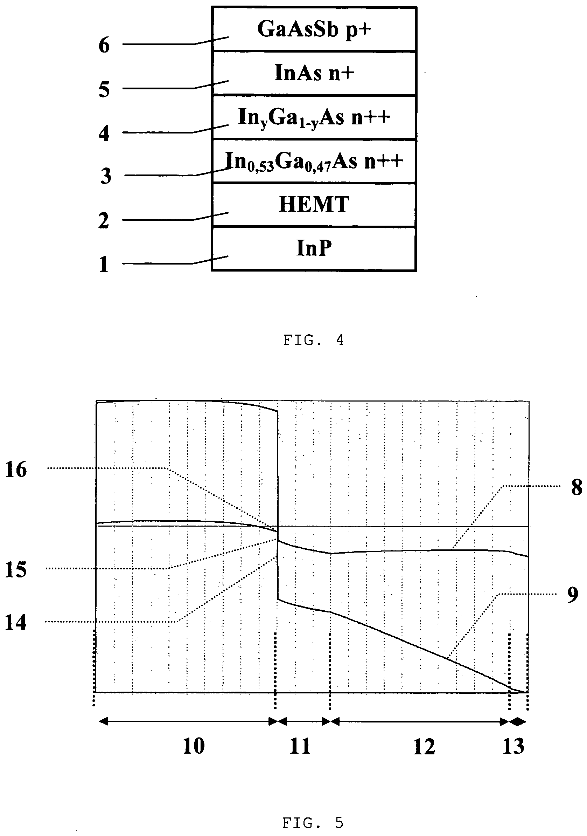

Selon un troisième mode de réalisation, cas particulier de celui de la figure 3, illustré à la figure 4, la structure semi-conductrice comprend encore deux couches : une couche 1 substrat composé de matériau semi-conducteur InP ou GaAs métamorphique, un ensemble HEMT 2 composé de plusieurs couches de matériaux semi-conducteurs, destiné à la réalisation de transistors à haute mobilité électronique HEMT, dont la couche supérieure 3 est composée de matériau semi-conducteur In_{0,53}Ga_{0,47}As. Plusieurs modes de réalisation de cet ensemble sont connus de l'homme du métier. A titre illustratif selon un mode de réalisation cet ensemble comprend dans l'ordre d'empilage :
- au dessus d'une couche 1 de substrat InP ou GaAs métamorphique,
- une couche Al_{0,52}In_{0,48}As,
- une couche In_{0,53}Ga_{0,47}As,
- une couche Al_{0,52}In_{0,48}As,
- une couche In_{0,53}Ga_{0,47}As, ou couche de contact qui se confond avec la couche support 3, et sur laquelle vient s'ancrer la couche graduelle 4.

Tous les constituants de cet ensemble HEMT 2 sont en accord de maille avec la couche substrat InP. La couche support 3 de In_{0,53}Ga_{0,47}As constitue la couche supérieure ou couche de contact typique d'un tel ensemble HEMT 2.

Ces différents modes de réalisation sont équivalents en ce qu'ils présentent les mêmes contraintes. La paramètre de maille du réseau cristallin d'un matériau semi-conducteur InP est identique au paramètre de maille du réseau cristallin d'un matériau semi-conducteur In_{0,53}Ga_{0,47}As.

Avantageusement, le In_{0,53}Ga_{0,47}As est fortement dopé N, ce que l'on note de manière classique n++.

Une manière avantageuse de réaliser la jonction permettant la réalisation des diodes RITD est de réaliser une couche dopée N 5 composée de InAs, surmontée, selon l'invention, d'une couche dopée P 6 GaAsₓSb₁₋ₓ. Une épaisseur de InAs de quelques Å, typiquement 20Å, est suffisante pour assurer le phénomène quantique qui permet l'effet tunnel. Ainsi avec une épaisseur typique de GaAsSb de 80À, il est possible d'obtenir une jonction RITD sur une épaisseur totale de 100Å.

La présence de la couche graduelle 4 sous la couche dopée N 5 garantit l'absence de puits quantiques qui réduiraient à néant l'effet tunnel obtenu par la jonction PN et autorise ainsi la réalisation de RITD sur une base InAs/GaAsSb ce qui ne serait en son absence pas possible du fait de l'apparition de puits quantiques.

Comme vu précédemment, le couple de matériaux semi-conducteurs InAs/GaAsSb, des couches respectives dopée N 5 et dopée P 6, ne nécessite qu'un dopage faible pour développer l'effet tunnel. Afin de réaliser l'accord de maile entre la couche dopée P 6 et la couche support 3 (InP et/ou In_{0,53}Ga_{0,47}As) x est avantageusement choisi égal à 0,51.

Il est acceptable ici, de désaccorder la maille pour la couche dopée P 6. Il est ainsi possible de faire varier x, selon l'invention, entre 0,35 et 0,65. Cette variation favorise ou réduit l'effet tunnel, avec une influence sur la caractéristique de la diode RITD obtenue et notamment sur la gamme de tension présentant une résistance négative.

Afin de produire une couche graduelle 4 présentant un paramètre de maille graduellement évolutif entre le premier paramètre de maille du support 3 et le second paramètre de maille de la couche dopée N, la couche graduelle est avantageusement composée de matériau semi-conducteur In_{y}Ga_{1-y}As, avec y variant graduellement en fonction de l'épaisseur de ladite couche graduelle, entre une valeur y sensiblement égale à 0,53 au contact de la couche support 3 et une valeur y sensiblement égale à 1 au contact de la couche dopée N 5. Ladite couche graduelle présente une épaisseur typique comprise entre quelques dizaines et quelques centaines d'Å.

L'ensemble des couches constitutives de la structure est réalisé par croissance épitaxiale selon les méthodes connues de l'homme du métier. De même la couche graduelle est produite par croissance épitaxiale en faisant progressivement varier y en fonction de l'épaisseur de la couche graduelle 4, à mesure que cette couche graduelle 4 est réalisée.

La variation de y est de préférence continue. Elle peut au choix suivre toute nature de loi, par exemple une loi linéaire.

A l'instar de certaines réalisation de diodes RITD connues, il est possible, entre les deux couches 5, 6 de la jonction diode, d'intercaler une couche intermédiaire, avec pour fonction une modération du courant. Cette couche intermédiaire est typiquement composée de GaAlSb mais peut aussi être composée de tout matériau capable de modérer l'effet tunnel au niveau de la jonction PN.

La figure 5 présente un diagramme de bande, classiquement utilisé dans le domaine. Un tel diagramme, figure en abscisse l'épaisseur de la structure semi-conductrice, ici 1 nm par graduation, et en ordonnée le niveau énergétique, en eV. A une abscisse donnée sont associées deux ordonnées, définissant deux courbes 8, 9. Ces deux courbes 8, 9 partagent verticalement l'espace en trois bandes. Au dessus de la courbe supérieure 8 se trouve la bande de conduction. En dessous de la courbe inférieure 9 se trouve la bande de valence. Entre ces deux bandes se trouve la bande interdite ou gap.

Il apparaît de gauche à droite 4 zones 10-13 correspondant aux différentes couches. La zone la plus à gauche 10 correspond à la couche dopée P 6. La zone 11 correspond à la couche dopée N 5. La discontinuité 14 des courbes 8, 9 entre ces deux couches est indicative de la jonction de type II permettant la réalisation de RITD. Le point 16 maximum de la bande de valence de la couche dopée P 6 est situé au dessus du point 15 minimum de la bande de conduction de la couche dopée N 5. La zone 12 correspond à la couche graduelle 4. On remarque que la variation de composition stoechiométrique appliquée en fonction de l'épaisseur de cette couche graduelle 4, qui a une influence sur le paramètre de maille permet aussi de faire varier les positions des bandes de valence et de conduction. La zone 13 correspond à la couche support 3. La variation graduelle des positions des bandes de valence et de conduction de la couche graduelle 4 permet de raccorder sans discontinuité les bandes de valence et de conduction de la couche dopée N 5 et de la couche support 3.

A partir de la structure selon l'un des modes de réalisation de l'invention, l'homme du métier connaît les différentes étapes technologiques permettant la fabrication dans la structure des composants électroniques (diodes, transistors, RITD, HEMT,...) afin de réaliser un circuit intégré.

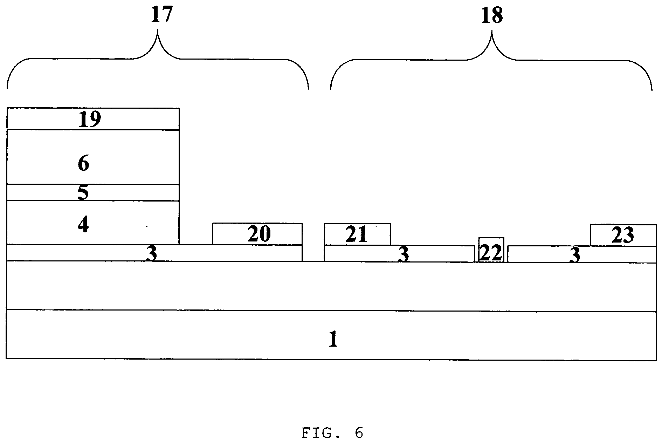

La figure 6 illustre un exemple de réalisation, à intégration monolithique, dans lequel une structure semi-conductrice selon un mode de réalisation de la présente invention a été usinée pour obtenir un transistor HEMT 18 et une diode RITD 17. Ainsi sur cette figure on retrouve l'empilage comprenant : une couche substrat 1, un ensemble de couches HEMT 2, une couche supérieure de contact 3, une couche graduelle 4, une couche N 5 et une couche P 6. Dans la zone gauche, ces couches ont été usinées afin de réalisation d'une diode RITD 17 dans les couches hautes 4, 5, 6, dotée de deux électrodes 19 et 20. Dans la zone droite, lesdites couches hautes ont été totalement retirées, afin de permettre la fabrication d'un transistor HEMT 18 dans les couches basses 2, 3, doté d'une source 21, d'une grille 22 et d'un drain 23.

## Revendications

1. Structure semi-conductrice en couches superposées pour réalisation de circuit intégré comprenant dans l'ordre d'empilage :
- une couche support (3) composée d'un matériau semi-conducteur III-V présentant un premier paramètre de maille,
- une couche dopée N (5) composée d'un matériau semi-conducteur III-V présentant un deuxième paramètre de maille différent du premier paramètre de maille,
- une couche dopée P (6) composée d'un matériau semi-conducteur III-V GaAsₓSb₁₋ₓ, faiblement dopé, avec x compris entre 0,35 et 0,65, la couche dopée N (5) et la couche dopée P (6) formant une hétérojonction de type II, c'est à dire une hétérojonction dans laquelle le minimum de la bande de conduction de la couche dopée N (5) est situé au dessous du maximum de la bande de valence de la couche dopée P (6), et ainsi apte à la réalisation d'une diode à effet tunnel à résonance inter bande, RITD, et
- entre la couche support (3) et la couche dopée N (5), une couche graduelle (4) composée d'un matériau semi-conducteur III-V dont la composition stoechiométrique varie graduellement en fonction de l'épaisseur de ladite couche graduelle (4) afin de présenter un paramètre de maille variant graduellement en fonction de l'épaisseur de ladite couche graduelle (4), sensiblement égal au premier paramètre de maille au contact de la couche support (3) et sensiblement égal au deuxième paramètre de maille au contact de la couche dopée N (5).

2. Structure selon la revendication 1, où la couche support (3) est un substrat composé de matériau semi-conducteur InP ou GaAs métamorphique.

3. Structure selon la revendication 1, où la couche support (3) est une couche composée de matériau semi-conducteur In_{0,53}Ga_{0,47}As.

4. Structure selon la revendication 3, comprenant encore dans l'ordre d'empilage :
- un substrat en matériau semi-conducteur InP (1) ou GaAs métamorphique,
- un ensemble HEMT (2) composé de plusieurs couches de matériaux semi-conducteurs, apte à la réalisation de transistors à haute mobilité électronique, HEMT, comportant une couche supérieure (3) composée de matériau semi-conducteur In_{0,53}Ga_{0,47}As qui se confond avec la couche support (3).

5. Structure selon la revendication 3 ou 4, où le matériau semi-conducteur In_{0,53}Ga_{0,47}As est fortement dopé N, n++.

6. Structure selon l'une quelconque des revendications 1 à 5, où la couche dopée N (5) est une couche composée de matériau semi-conducteur InAs, faiblement dopé.

7. Structure selon l'une quelconque des revendications 1 à 6, où x est sensiblement égal à 0,51.

8. Structure selon l'une quelconque des revendications 1 à 7, où la couche graduelle (4) est une couche composée de matériau semi-conducteur In_{y}Ga_{1-y}As, avec y variant graduellement en fonction de l'épaisseur de ladite couche graduelle, entre une valeur y sensiblement égale à 0,53 au contact de la couche support (3) et une valeur y sensiblement égale à 1 au contact de la couche dopée N (5).

9. Structure selon la revendication 8, où la variation de y suit une loi continue.

## Patentansprüche

1. Halbleiterstruktur aus übereinanderliegenden Schichten zur Ausführung einer integrierten Schaltung, umfassend, in der Stapelreihenfolge:
- eine aus einem III-V-Halbleitermaterial bestehende Trägerschicht (3), die einen ersten Gitterparameter aufweist,
- eine aus einem III-V-Halbleitermaterial bestehende N-dotierte Schicht (5), die einen zweiten Gitterparameter aufweist, welcher sich vom ersten Gitterparameter unterscheidet,
- eine aus einem schwach dotierten III-V-GaAsₓSb₁₋ₓ-Halbleitermaterial bestehende P-dotierte Schicht (6), wobei x im Bereich zwischen 0,35 und 0,65 liegt, wobei die N-dotierte Schicht (5) und die P-dotierte Schicht (6) einen Heteroübergang vom Typ II bilden, das heißt einen Heteroübergang, bei dem das Minimum des Leitungsbandes der N-dotierten Schicht(5) unter dem Maximum des Valenzbandes der P-dotierten Schicht (6) liegt, und die so zur Ausführung einer Resonant-Interband-Tunneldiode, RITD, geeignet ist, und
- zwischen der Trägerschicht (3) und der N-dotierten Schicht (5) eine aus einem III-V-Halbleitermaterial bestehende graduelle Schicht (4), deren stöchiometrische Zusammensetzung abhängig von der Dicke der graduellen Schicht (4) graduell variiert, sodass sie einen abhängig von der Dicke der graduellen Schicht (4) graduell variierenden Gitterparameter aufweist, der im Kontakt mit der Trägerschicht (3) im Wesentlichen gleich dem ersten Gitterparameter ist, und im Kontakt mit der N-dotierten Schicht (5) im Wesentlichen gleich dem zweiten Gitterparameter ist.

2. Struktur nach Anspruch 1, wobei die Trägerschicht (3) ein aus metamorphem InP- oder GaAs-Halbleitermaterial bestehendes Substrat ist.

3. Struktur nach Anspruch 1, wobei die Trägerschicht (3) eine aus In_{0,53}Ga_{0,47}As-Halbleitermaterial bestehende Schicht ist.

4. Struktur nach Anspruch 3, die in der Stapelreihenfolge weiter umfasst:
- ein Substrat aus metamorphem InP- (1) oder GaAs-Halbleitermaterial,
- eine aus mehreren Halbleitermaterialschichten bestehende HEMT-Anordnung (2), die zum Ausführen von Transistoren mit hoher Elektronenbeweglichkeit, HEMT, geeignet ist, umfassend eine aus In_{0,53}Ga_{0,47}As-Halbleitermaterial bestehende obere Schicht (3), die mit der Trägerschicht (3) verschmilzt.

5. Struktur nach Anspruch 3 oder 4, wobei das In_{0,53}Ga_{0,47}As-Halbleitermaterial stark, n++, N-dotiert ist.

6. Struktur nach einem der Ansprüche 1 bis 5, wobei die N-dotierte Schicht (5) eine aus schwach dotiertem InAs-Halbleitermaterial bestehende Schicht ist.

7. Struktur nach einem der Ansprüche 1 bis 6, wobei x im Wesentlichen gleich 0,51 ist.

8. Struktur nach einem der Ansprüche 1 bis 7, wobei die graduelle Schicht (4) eine aus In_{y}Ga_{1-y}As-Halbleitermaterial bestehende Schicht ist, wobei y abhängig von der Dicke der graduellen Schicht graduell zwischen einem Wert y, der im Kontakt mit der Trägerschicht (3) im Wesentlichen gleich 0,53 ist, und einem Wert y variiert, der im Kontakt mit der N-dotierten Schicht (5) im Wesentlichen gleich 1 ist.

9. Struktur nach Anspruch 8, wobei die Variation von y einem steten Gesetz folgt.

## Claims

1. Semiconductor structure in overlaid layers for integrated circuit production comprising in the order of stacking:
- a substrate layer (3) composed of a III-V semiconductor material having a first lattice parameter,
- an N-doped layer (5) composed of a III-V semiconductor material having a second lattice parameter different from the first lattice parameter,
- a P-doped layer (6) composed of a weakly doped III-V semiconductor material GaAsₓSb₁₋ₓ, where x is between 0.35 and 0.65, the N-doped layer (5) and P-doped layer (6) forming a type II heterojunction, i.e. a heterojunction wherein the minimum of the conduction band of the N-doped layer (5) is situated below the maximum of the valence band of the P-doped layer (6), and thus suitable for producing a resonant interband tunnel diode, RITD, and
- between the substrate layer (3) and the N-doped layer (5), a gradual layer (4) composed of a III-V semiconductor material the stoichiometric composition whereof varies gradually according to the thickness of said gradual layer (4) so as to have a lattice parameter varying gradually according to the thickness of said gradual layer (4), substantially equal to the first lattice parameter in contact with the substrate layer (3) and substantially equal to the second lattice parameter in contact with the N-doped layer (5).

2. Structure according to claim 1, wherein the substrate layer (3) is a substrate composed of metamorphic InP or GaAs semiconductor material.

3. Structure according to claim 1, wherein the substrate layer (3) is a layer composed of semiconductor material In_{0.53}Ga_{0.47}As.

4. Structure according to claim 3, further comprising in the order of stacking:
- a substrate made of metamorphic InP (1) or GaAs material,
- an HEMT assembly (2) composed of a plurality of layers of semiconductor materials, suitable for producing high electron mobility transistors, HEMTs, including an upper layer (3) composed of semiconductor material In_{0.53}Ga_{0.47}As which merges with the substrate layer (3).

5. Structure according to claim 3 or 4, wherein the semiconductor material In_{0.53}Ga_{0.47}As is strongly N-doped, n++.

6. Structure according to any one of claims 1 to 5, wherein the N-doped layer (5) is a layer composed of weakly doped InAs semiconductor material.

7. Structure according to any one of claims 1 to 6, wherein x is substantially equal to 0.51.

8. Structure according to any one of claims 1 to 7, wherein the gradual structure (4) is a layer composed of semiconductor material In_{y}Ga_{1-y}As, where y varies gradually according to the thickness of said gradual layer, between a value y substantially equal to 0.53 in contact with the substrate layer (3) and a value y substantially equal to 1 in contact with the N-doped layer (5).

9. Structure according to claim 8, wherein the variation of y observes a continuous law.
